Europäisches Patentamt

European Patent Office

Office européen des brevets

(11) Veröffentlichungsnummer: **0 129 789**
**A2**

(12) # EUROPÄISCHE PATENTANMELDUNG

(21) Anmeldenummer: **84106815.8**

(22) Anmeldetag: **14.06.84**

(51) Int. Cl.⁴: **H 03 K 17/95**

(30) Priorität: **21.06.83 JP 111656/83**

(43) Veröffentlichungstag der Anmeldung:
**02.01.85 Patentblatt 85/1**

(84) Benannte Vertragsstaaten:
**DE FR GB IT**

(71) Anmelder: **FUJI ELECTRIC CO. LTD.**
**1-1, Tanabeshinden, Kawasaki-ku**
**Kawasaki 210(JP)**

(72) Erfinder: **Kiyoshi, Tanigawa**
**10-23 Fukiagecho Minami 2-chome Kitaadachigun**
**Saitama-ken, 369-1(JP)**

(72) Erfinder: **Fumito, Takahashi**
**5108-14 Saitama**
**Gyoda-shi Saitama-ken(JP)**

(74) Vertreter: **Mehl, Ernst, Dipl.-Ing. et al,**
**Postfach 22 01 76**
**D-8000 München 22(DE)**

(54) **Näherungsschalter.**

(57) Die Erfindung bezieht sich auf einen berührungslosen Näherungsschalter mit einem durch ein metallisches Objekt (1) verstimmbaren Resonanzkreis (2, 3), dessen Niveauänderung mit einem vorbestimmbaren Erfassungsniveau verglichen einen Ausgangssignalwechsel des Schalters hervorruft. Die Niveauänderung oder das Erfassungsniveau sind mit einer periodischen Niveauumschaltung (9, 10, 4)versehen, und zwar derart, daß das Ausgangssignal des Schalters zwischen zwei Bereichen periodisch den Schaltzustand wechselt, von denen der Aus-Bereich bei sich vom Schalter enternendem Objekt (1) und der Ein-Bereich bei sich dem Schalter nähernden Objekt (1) beginnt.

FIG 1

EP 0 129 789 A2

Fuji Electric Co., Ltd.  
Kawasaki, Japan

Mein Zeichen  
VPA 83 P 8552 E

**Näherungsschalter**

Die Erfindung bezieht sich auf einen berührungslosen Näherungsschalter mit einem durch ein metallisches Objekt verstimmbaren Resonanzkreis, dessen Niveauänderung mit einem vorbestimmbaren Erfassungsniveau verglichen einen Ausgangssignalwechsel des Schalters hervorruft.

Bei einem bekannten Näherungsschalter der obengenannten Art schaltet der Schalter direkt bei Erreichen des vorbestimmbaren Niveaus von der einen in die andere Schaltlage. Es ist somit nur möglich festzustellen, ob das Objekt sich vor oder hinter dem vorbestimmbaren Schaltpunkt befindet. Durch die vorliegende Erfindung soll ein Näherungsschalter der obengenannten Art bei einfachem Aufbau derart verbessert werden, daß die Lage des Objekts zuverlässig festgestellt werden kann, bevor es in den eigentlichen Schaltbereich eintritt. Dies wird auf einfache Weise dadurch erreicht, daß die Niveauänderung oder das Erfassungsniveau mit einer periodischen Niveauumschaltung versehen sind, derart, daß das Ausgangssignal des Schalters zwischen zwei Bereichen periodisch den Schaltzustand wechselt, von denen der Aus-Bereich bei sich vom Schalter entfernendem Objekt und der Ein-Bereich bei sich dem Schalter näherenden Objekt beginnt. Eine einfache Ausführungsform des erfindungsgemäßen Schalters ergibt sich, wenn zur periodischen Niveauumschaltung ein die Verstärkung eines IC ändernder Oszillator dient. Hierbei hat es sich als vorteilhaft erwiesen, wenn ein vom Oszillator angesteuerter Transistor zum Kurzschließen eines Teils des Verstärkungswiderstandes dient.

La 2 Syr / 04.06.1984

Anhand der Zeichnung wird ein Ausführungsbeispiel gemäß der Erfindung beschrieben.

Es zeigen:

Fig. 1 ein Schaltschema für den erfindungsgemäßen Näherungsschalter,

Fig. 2 die Darstellung der Wirkungsweise des Näherungsschalters nach Fig. 1,

Fig. 3 eine weitere Ausführungsform als Schaltschema des Erfindungsgegenstandes und

Fig. 4 ein Funktionsdiagramm der Schaltungsanordnung nach Fig. 3.

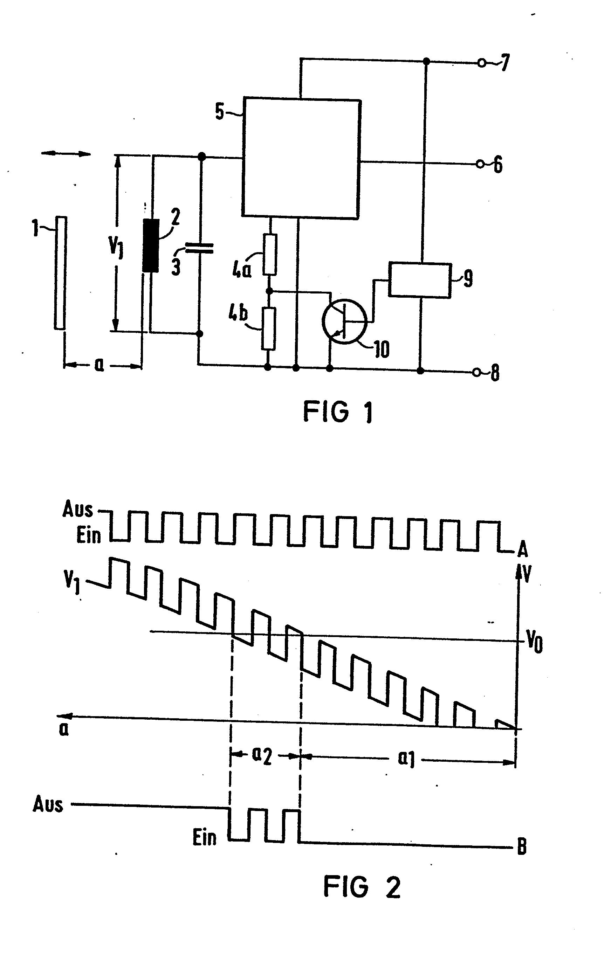

In der Schaltung nach Fig. 1 ist ein IC 5 vorgesehen, der u.a. den Oszillatorkreis, einen Kreis zur Gleichrichtung und Glättung der Oszillatorspannung, einen Spannungserfassungskreis, um das Niveau der geglätteten Spannung zu erfassen, enthält. Eine Oszillatorspule 2 ist mit dem Kondensator 3 in Parallelschaltung zur Bildung des Schwingkreises zusammengeschaltet. Ein Empfindlichkeitseinstellungswiderstand 4, im Beispiel nach Fig. 1 aus den Teilwiderständen 4a und 4b bestehend, ist vorgesehen, um die Verstärkung des Oszillatorkreises in dem IC 5 einstellen zu können. Die Ausgangsklemme ist mit 6, die Klemmen für die Spannungsversorgung sind mit 7 und 8 bezeichnet. Mit a ist der Abstand zwischen einem zu erfassenden Objekt 1 und der Oszillatorspule 2 bezeichnet. Nähert sich das Objekt 1 der Spule 2, nimmt die Spannung $V_1$ an der Spule 2 graduell ab mit zunehmender Annäherung des Objektes 1. Ein Oszillator 9 übermittelt sein Signal an den Transistor 10. Der Oszillator 9 und der Transistor 10 stellen zusammen eine Niveauumschaltung dar, die wiederholt das Niveau eines Eingangssignales auf den IC 5 verschiebt. Der Transistor 10 wiederholt die Ein-Aus-Schaltung, wie dies unter A in Fig. 2 zu ersehen ist, um damit die Wiederholung des Kurzschließens und Öffnens

der Verstärkungswiderstände 4a, 4b, hier den Widerstand 4b, zu wiederholen, um hierdurch die Verstärkung des Oszillatorkreises, der nicht dargestellt ist, im IC einzuregeln. Entsprechend wird die Oszillatorspannung $V_1$ an der Spule 2 groß sein, wenn der Transistor 10 eingeschaltet ist, aber klein, wenn der Transistor 10 ausgeschaltet ist. Diese Beziehung wird unabhängig von der Annäherung des metallischen Objektes an die Oszillatorspule 2 beibehalten. Sobald die Oszillatorspannung $V_1$ das zu erfassende Niveau $V_0$ der Spannung erreicht, springt das Ausgangssignal B an der Ausgangsklemme 6 vom Aus-Zustand in den Ein-Zustand. Solange sich das Objekt 1 jedoch innerhalb des Zwischenbereiches $a_2$ befindet, schneidet die Oszillatorspannung $V_1$ das Spannungserfassungsniveau $V_0$, so daß das Ausgangssignal B die Ein-Aus-Umschaltungsoperation wiederholt. Nähert sich das Objekt 1 der Oszillatorspule 2 weiter, wechselt das Ausgangssignal B in den Ein-Zustand, um anzuzeigen, daß das metallische Objekt 1 in dem Erfassungsbereich $a_1$ liegt.

Das Ausgangssignal B, das den Ein-Aus-Zustand wiederholt, solange sich das Objekt 1 in dem Zwischenbereich $a_2$ befindet, kann als Gleichspannungssignal herausgezogen werden, und zwar aus einem nicht dargestellten Glättungskreis des IC 5.

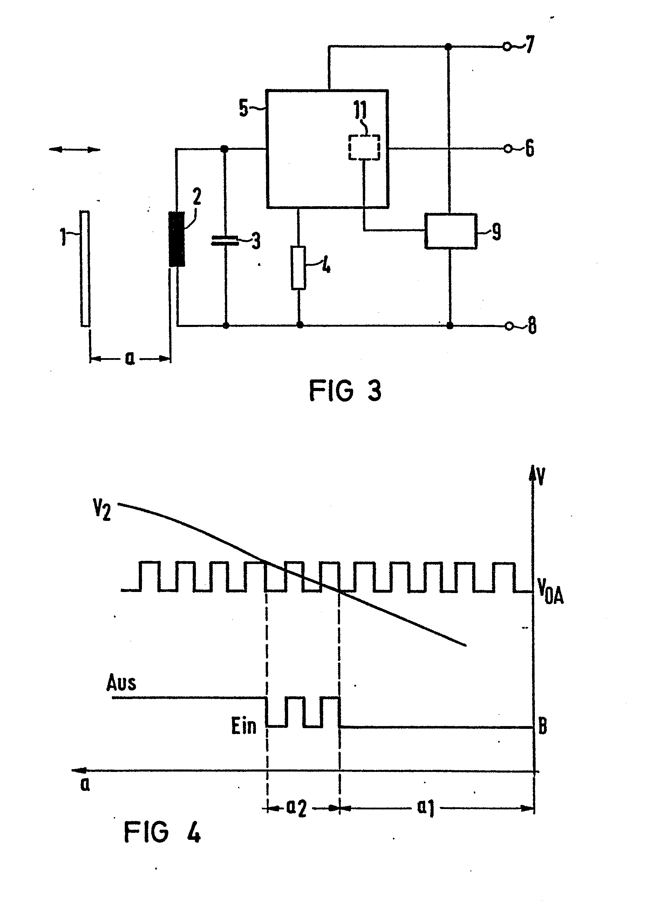

Fig. 3 zeigt das Schaltschema für eine weitere Ausführungsform des Gegenstandes der Erfindung. Gleichwirkende Teile sind mit gleichen Bezugzeichen versehen. In dieser Ausführungsform ist ein Spannungserfassungskreis 11 im IC 5 vorgesehen, der ein Spannungserfassungsniveau $V_{0A}$ besitzt, das zwischen zwei Zuständen wechselt, und zwar in Abhängigkeit von der Wellenform des Ausganges des Oszillators 9 mit den Niveauumschaltmitteln. Bei der Annäherung des Objektes 1 an die Oszillatorspule 2 nimmt die Oszillatorspannung $V_2$ stetig ab. Sobald die Spannung $V_2$ des Spannungserfassungsniveau $V_{0A}$ kreuzt, während das Objekt 1 in dem Zwischenbereich $a_2$ sich befindet, wiederholt das

- 4 -    VPA 83 P 8552 E

Ausgangssignal B an der Ausgangsklemme 6 die Ein-Aus-Schaltung. Nähert sich das metallische Objekt 1 der Oszillatorspule 2 weiter, wechselt das Ausgangssignal B in den Ein-Zustand, um anzuzeigen, daß das metallische Objekt im Erfassungsbereich $a_1$ liegt.

Wie vorn beschrieben, ist der Näherungsschalter gemäß der Erfindung mit Niveauumschaltmitteln versehen, die wiederholt entweder das Niveau des Eingangssignals oder der Spannungserfassung verschieben, um ein Ausgangssignal zu erhalten, das wiederholt Ein und Aus wiedergibt und zwar zwischen dem Aus-Bereich, in dem der Schalter ausgeschaltet wird, während das zu erfassende Objekt sich von diesem weg bewegt, und der Bereich des Ein-Zustandes, wo der Schalter eingeschaltet wird, indem sich das Objekt diesem nähert. Entsprechend ist das durch den Stand der Technik aufgezeigte Problem effektiv gelöst und der Näherungsschalter ist einfach im Aufbau. Zusätzlich ist es möglich, zuverlässig die Tatsache zu erfassen, daß das zu erfassende Objekt gegenwärtig sich im Zwischenbereich befindet, ohne hier die Anzahl der Ausgangsklemmen erhöhen zu müssen.

3 Patentansprüche
4 Figuren

0129789

- 5 -                    VPA 83 P 8552 E

Patentansprüche

1. Berührungsloser Näherungsschalter mit einem durch ein metallisches Objekt verstimmbaren Resonanzkreis, dessen Niveauänderung mit einem vorbestimmbaren Erfassungsniveau verglichen einen Ausgangssignalwechsel des Schalters hervorruft, d a d u r c h   g e k e n n z e i c h n e t, daß die Niveauänderung oder das Erfassungsniveau mit einer periodischen Niveauumschaltung (9, 10, 4; 9, 11, 4) versehen sind, derart, daß das Ausgangssignal des Schalters zwischen zwei Bereichen ($a_2$) periodisch den Schaltzustand wechselt, von denen der Aus-Bereich (a) bei sich vom Schalter entfernendem Objekt (1) und der Ein-Bereich ($a_1$) bei sich dem Schalter nähernden Objekt (1) beginnt.

2. Näherungsschalter nach Anspruch 1, d a d u r c h   g e k e n n z e i c h n e t , daß zur periodischen Niverauumschaltung ein die Verstärkung (4a, 4b) eines IC (5) ändernder Oszillator (9) dient.

3. Näherungsschalter nach Anspruch 2, d a d u r c h   g e k e n n z e i c h n e t , daß ein vom Oszillator (9) angesteuerter Transistor (10) zum Kurzschließen eines Teils (4b) des Verstärkungswiderstandes (4) dient.

FIG 1

FIG 2

83 P 8552

FIG 3

FIG 4